(19) Europäisches Patentamt
European Patent Office
Office européen des brevets

(11) Veröffentlichungsnummer: **0 141 921**
**B1**

(12) # EUROPÄISCHE PATENTSCHRIFT

(45) Veröffentlichungstag der Patentschrift: **13.05.87**

(51) Int. Cl.⁴: **G 03 C 1/68**

(21) Anmeldenummer: **84109345.3**

(22) Anmeldetag: **07.08.84**

(54) **Durch Strahlung polymerisierbares Gemisch und daraus hergestelltes Kopiermaterial.**

(30) Priorität: **16.08.83 DE 3329443**

(43) Veröffentlichungstag der Anmeldung: **22.05.85 Patentblatt 85/21**

(45) Bekanntmachung des Hinweises auf die Patenterteilung: **13.05.87 Patentblatt 87/20**

(84) Benannte Vertragsstaaten: **AT BE CH DE FR GB IT LI NL SE**

(56) Entgegenhaltungen:
**EP - A - 0 073 444**
**DE - A - 2 509 842**
**DE - A - 2 613 098**

(73) Patentinhaber: **HOECHST AKTIENGESELLSCHAFT, Postfach 80 03 20, D-6230 Frankfurt am Main 80 (DE)**

(72) Erfinder: **Geissler, Ulrich, Dr., Altenauer Strasse 34, D-6203 Hochheim am Main (DE)**

**EP 0 141 921 B1**

Anmerkung: Innerhalb von neun Monaten nach der Bekanntmachung des Hinweises auf die Erteilung des europäischen Patents im Europäischen Patentblatt kann jedermann beim Europäischen Patentamt gegen das erteilte europäische Patent Einspruch einlegen. Der Einspruch ist schriftlich einzureichen und zu begründen. Er gilt erst als eingelegt, wenn die Einspruchsgebühr entrichtet worden ist (Art. 99(1) Europäisches Patentübereinkommen).

ACTORUM AG

**Beschreibung**

Die Erfindung betrifft ein durch Strahlung polymerisierbares Gemisch, das als wesentliche Bestandteile

a) eine Verbindung mit mindestens zwei endständigen ethylenisch ungesättigten Gruppen, die durch radikalisch initiierte Additionskettenpolymerisation ein vernetztes Polymerisat zu bilden vermag,
b) ein polymeres Bindemittel und
c) einen durch Strahlung aktivierbaren Polymerisationsinitiator

enthält und das bevorzugt als trocken übertrabgares Photoresistmaterial zur Herstellung von Lötstopmasken verwendet wird.

Es ist bekannt, Lötstopmasken auf Leiterplatten nach der Photoresisttechnik herzustellen. Ebenso wie bei der Herstellung gedruckter Schaltungen werden hier thermoplastische photopolymerisierbare Schichten unter Druck und Erwärmen auf die Leiterplatte laminiert und bildmässig an den Stellen durch Belichten gehärtet, an denen die Leiterplatte abgedeckt werden soll. Durch Auswaschen der unbelichteten Schichtstellen erhält man die Lötstopmaske.

Hierfür geeignete Materialien sind z.B. in der DE-A 2 747 947 beschrieben. Es handelt sich hierbei um photopolymerisierbare Schichten, die zur Verbesserung der Flammwidrigkeit eine bestimmte Menge gebundenes Halogen enthalten. Ein ähnliches Material ist in der EP-A 15 004 beschrieben, das sich trocken durch mechanisches Trennen von belichteten und belichteten Schichtbereichen entwickeln lässt («peel-apart-Verfahren»). Schliesslich wird in der EP-A 2040 ein für den gleichen Zweck bestimmtes lichthärtbares Material beschrieben, bei dem als lichtempfindliche Verbindungen nicht näher bezeichnete lichtempfindliche Epoxyharze verwendet werden.

Die Für diesen Zweck bekannten und verwendeten photopolymerisierbaren Gemische werden trocken und unter Erwärmen auf die zu maskierende Leiterplatte übertragen und müssen deshalb notwendig thermoplastisch sein. Diese Eigenschaft ist jedoch nachteilig bei der Verwendung als Lötstopmasken, da diese Temperaturen oberhalb 200 °C ohne Zersetzung und ohne zu starkes Erweichen oder gar Schmelzen überstehen müssen. Zwar wird die Photopolymerschicht an den belichteten Stellen durch vernetzende Polymerisation wesentlich gehärtet, und diese Lichthärtung lässt sich durch Nachbelichten der entwickelten Bildschablone in in bekannter Weise noch verstärken. Es bleibt jedoch grundsätzlich eine Erweichungstendenz beim Erwärmen von allen bekannten photopolymerisierbaren Schichten.

Um diesen Nachteil zu beheben, wurde gemäss der DE-A 3 114 931 dem photopolymerisierbaren Gemisch für die Herstellung der Lötstopmaske eine Bis-Epoxyverbindung zugesetzt und die lichtgehärtete Bildschablone nach dem Entwickeln durch Erhitzen nachgehärtet. Nach diesem Verfahren werden sehr temperaturbeständige Lötstopmasken erhalten. Das photopolymerisierbare Gemisch hat jedoch den Nachteil einer geringeren Lagerfähigkeit gegenüber einem sonst gleichen Gemisch, das keine Epoxyverbindung enthält.

In der EP-A 73 444 werden ähnliche Gemische beschrieben, die im unbelichteten Zustand eine höhere Lagerfähigkeit aufweisen. Die Gemische enthalten Verbindungen, die mit dem Bindemittel, dem Polymerisationsprodukt der ethylenisch ungesättigten Verbindung und/oder mit sich selbst thermisch vernetzbar sind. Bevorzugt werden solche Verbindungen eingesetzt, die als vernetzende Gruppen Epoxygruppen oder Gruppen der Formel $-CH_2-O-R$ enthalten, worin R ein Wasserstoffatom, eine niedere Alkyl-, Acyl- oder Hydroxyalkylgruppe ist und in denen die Gruppen $-CH_2OR$ an einem Stickstoffatom eines niedermolekularen offenkettigen oder cyclischen Säureamids oder an einem aromatischen Kohlenstoffatom einer zur Kondensation mit Formaldehyd befähigten Verbindung stehen.

Die in dieser Druckschrift beschriebenen Gemische weisen jedoch noch zwei entscheidende Nachteile auf. Zum einen kommt es unter bestimmten Lötbedingungen vor, dass — vermutlich infolge Erweichung der Schicht — nach dem Schwall-Löten Fäden oder Kügelchen der Lötlegierung an der Oberfläche der Lötstopmaske haften bleiben, was unter Umständen zu Kurzschlüssen führen kann.

Das Auftreten dieser sogenannten «Zinnspinnweben» kann — wie in der nicht vorveröffentlichten älteren deutschen Patentanmeldung P 3 236 560.8 beschrieben — durch Aufrauhung der Photopolymerschicht mittels einer pigmentierten Polyesterfolie vermindert werden. Es kann jedoch hierdurch nicht vollkommen ausgeschlossen werden.

Weiterhin weisen die Gemische der EP-A 73 444 im ausgehärteten Zustand eine unzureichende Lösemittelresistenz auf. Beim Reinigen der gelöteten Leiterplatten kann es zum Erweichen der Lötstopmasken. Ausserdem wird bei längeren Einwirkzeiten von Lösemitteln, z.B. Ethanol, der Farbstoff teilweise aus der Schicht herausgelöst.

Aufgabe der Erfindung war es, zur Herstellung von thermisch nachhärtbaren Bildschablonen geeignete photopolymerisierbare Gemische vorzuschlagen, die eine gleich gute Lagerstabilität wie die bekannten Gemische haben, deren Belichtungsprodukte aber härter und resistenter gegen Lösemittel sind.

Erfindungsgemäss wird ein durch Strahlung polymerisierbares Gemisch vorgeschlagen, das

a) eine Verbindung mit mindestens zwei endständigen ethylenisch ungesättigten Gruppen, die durch radikalisch initiierte Additionskettenpolymerisation ein vernetztes Polymerisat zu bilden vermag,
b) ein polymeres Bindemittel und
c) einen durch Strahlung aktivierbaren Polymerisationsinitiator

enthält.

Das erfindungsgemässe Gemisch ist dadurch gekennzeichnet, dass es als Bindemittel ein Mischpolymerisat mit Einheiten der Formel

R'<br>
|<br>
$-CH_2-C-$<br>
|<br>
CO<br>
|<br>
NH<br>
|<br>
$CH_2$<br>
|<br>
OR

enthält, worin

R' ein Wasserstoffatom oder eine Methylgruppe ist und

R ein Wasserstoffatom, eine niedere Alkyl-, Acyl- oder Hydroxyalkylgruppe ist.

Wenn R eine Alkylgruppe ist, enthält diese im allgemeinen 1 bis 6, bevorzugt 1 bis 4 Kohlenstoffatome; wenn es eine Acylgruppe ist, hat diese im allgemeinen 1 bis 4, bevorzugt 1 bis 2 Kohlenstoffatome. Verbindungen mit R = Alkyl werden im allgemeinen bevorzugt.

Ausser den Einheiten der oben angegebenen Formel kann das Mischpolymerisat weitere Einheiten, vorzugsweise solche, die Polymere mit niedrigem Tg-Wert ergeben, insbesondere Acryl- oder Methacrylsäureestereinheiten enthalten.

Die Polymeren mit den oben bezeichneten Monomereinheiten ergeben beim Erhitzen in Gegenwart von Polymeren mit freien Hydroxyl- oder vorzugsweise Carboxylgruppen vernetzte Produkte. Sie können demgemäss im Gemisch mit polymeren Bindemitteln vorliegen, die solche Substituenten enthalten. Bevorzugt werden Bindemittel verwendet, die beide Arten von funktionellen Einheiten in einem Molekül enthalten. Als solche kommen insbesondere Terpolymerisate von substituierten Acryl- oder Methacrylsäureamiden, Acryl- oder Methacrylsäure und Alkylestern der Acryl- oder Methacrylsäure in betracht. Die Methacrylsäureester werden dabei besonders bevorzugt, insbesondere solche mit 4 bis 12 C-Atomen in der Alkylgruppe. Werden Acrylsäureester verwendet, so kann die Alkylgruppe auch kürzer sein.

Zusätzlich können die Polymerisate kleine Mengen an Hydroxyalkylacrylaten oder -methacrylaten einpolymerisiert enthalten.

Die beim Erhitzen des Gemischs erzielte Vernetzungsdichte hängt von dem Verhältnis von substituierten Säureamidgruppen zu den Carbonsäure- und bzw. oder OH-Gruppen ab. Vorteilhaft liegt das Molverhältnis $ROCH_2NH$ zu COOH zwischen 0,2 und 1,5:1, bevorzugt bei 0,5-1,1:1.

Der Mengenanteil an Carboxylgruppen enthaltenden Einheiten im Mischpolymerisat wird bestimmt durch die Forderung nach störungsfreier und möglichst rascher Entwicklung mit wässrig-alkalischen Lösungen, die vorzugsweise frei von organischen Lösungsmitteln sind, und nach möglichst grosser Entwicklerresistenz der belichteten Bereiche. Diese Eigenschaften werden in geringerem Masse auch durch das mittlere Molekulargewicht und die chemische und molekulare Uneinheitlichkeit des Polymeren beeinflusst. Im allgemeinen sollte die Säurezahl im Bereich von 50 bis 250, bevorzugt zwischen 100 und 220 liegen. Wenn ein Entwickler verwendet werden kann, der organische Lösungsmittel enthält, kann die Säurezahl auch kleiner sein.

Die bevorzugten Terpolymerisate enthalten normalerweise etwa 15-60, bevorzugt 20-50 Gew.-% an substituierten Säureamideinheiten. Der Mengenanteil an Acryl- oder Methacrylsäureeinheiten entspricht den oben angegebenen Säurezahlen; er liegt im allgemeinen bei 10-35 Gew.-%. Der Anteil an Alkylacrylat bzw. -methacrylat liegt im Bereich von 25 bis 75 Gew.-%. Die Methacrylsäure in freier Form und in Form des Alkylesters wird gegenüber der Acrylsäure bevorzugt.

Der Mengenanteil an Bindemitteln in dem polymerisierbaren Gemisch liegt im Bereich von 40 bis 90, vorzugsweise 55 bis 85 Gew.-%, bezogen auf dessen nichtflüchtige Bestandteile.

Die Bindemittel werden bevorzugt durch radikalische Polymerisation in organische Lösemitteln, z.B. Butanon oder Ethanol, hergestellt.

Als aktinische Strahlung, gegenüber der das erfindungsgemässe Gemisch empfindlich ist, kommt jede elektromagnetische Strahlung in Betracht, deren Energie zur Auslösung einer Polymerisation ausreicht. Geeignet sind insbesondere sichtbares und ultraviolettes Licht, Röntgen-, $\gamma$- und Elektronenstrahlung. Auch Laserstrahlung im sichtbaren und UV-Bereich kann verwendet werden. Bevorzugt wird kurzwelliges sichtbares und nahes UV-Licht.

Als polymerisierbare Verbindungen werden im allgemeinen Ester der Acryl- oder Methacrylsäure mit mehrwertigen, vorzugsweise primären, Alkoholen verwendet. Der Alkohol sollte 2 bis etwa 4 Hydroxygruppen enthalten, da durch mehrfach ungesättigte Verbindungen die erwünschte Vernetzungswirkung erreicht wird. In untergeordneter Menge können auch Ester von einwertigen oder höherwertigen Alkoholen im Gemisch enthalten sein. Beispiele für geeignete mehrwertige Alkohole sind Ethylenglykol, Propylenglykol, Butandiol-1,4, Butandiol-1,3, Diethylenglykol, Triethylenglykol, Polyethylenglykole oder Polypropylenglykole mit Molekulargewichten von etwa 200 bis 1000, Neopentylglykol, Trimethylolethan und -propan, Pentaerythrit und oxyethylierte Bisphenol-A-Derivate. Es sind ferner die niedermolekularen, Urethangruppen enthaltenden Bisacrylate und Bismethacrylate geeignet, die durch Umsetzen von 2 Mol Hydroxyalkylacrylat oder -methacrylat mit 1 Mol eines aliphatischen oder cycloaliphatischen Diisocyanats, z.B. 2,2,4-Trimethyl-hexamethylendiisocyanat, erhalten werden. Derartige Urethangruppen enthaltende Monomere sind in der US-A 4 088 498 beschrieben. Ähnliche geeignete Monomere sind in den DE-A-2 822 190 und 3 048 502 beschrieben.

Es können auch Gemische unterschiedlicher Monomerer verwendet werden. Zum Beispiel ist es möglich, Monomere der oben angegebenen Art mit höhermolekularen, Urethangruppen enthaltenden Monomeren der allgemeinen Formel

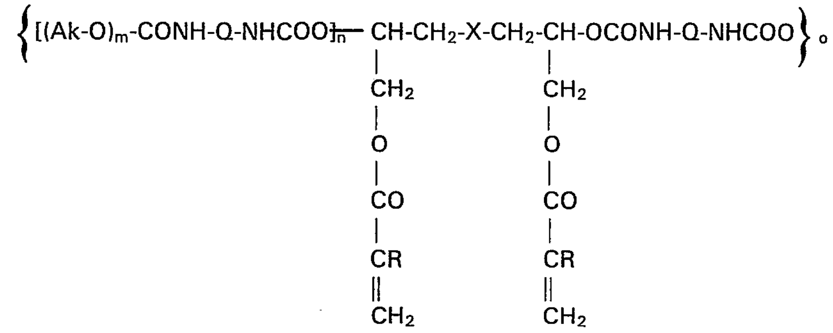

zu kombinieren, wobei

- Q ein zweiwertiger ein- oder zweikerniger aromatischer Rest, der unsubstituiert oder durch niedere Alkylgruppen substituiert ist und der als Bindeglied eine niedere Alkylengruppe enthalten kann,
- X eine der Gruppen
  -O-Ph-X'-Ph-O- und
  $-OOC-(CH_2)_y-COO-$,
  wobei Ph eine gegebenenfalls substituierte Phenylengruppe, X' eine Alkylengruppe mit 1-4 Kohlenstoffatomen und y eine Zahl von 2 bis 12 ist,
- R ein Wasserstoffatom oder eine Methylgruppe,
- Ak ein Alkylenrest mit 2-4 Kohlenstoffatomen,
- m eine Zahl von 4 bis 50,
- n eine Zahl von 1 bis 6 und
- o eine Zahl von 4 bis 20 ist.

Die Herstellung dieser Polyetheresterurethane erfolgt in bekannter Weise durch Umsetzen von oligomeren Diisocyanaten mit Bis-acrylsäureester-diolen.

Die Herstellung und Verwendung dieser Verbindungen ist in der EP-A 48 913 beschrieben.

Diese Polyurethane haben im allgemeinen reduzierte spezifische Viskositäten (RSV), gemessen an 1%igen Lösungen in Dimethylformamid bei 25°C, von etwa 0,15 bis 1,4 dl/g. Bevorzugt werden Produkte mit RSV-Werten im Bereich von 0,2 bis 0,9 dl/g.

Die Gesamtmenge an polymerisierbaren Verbindungen liegt im allgemeinen zwischen 10 und 60, vorzugsweise bei 15 bis 45 Gew.-%, bezogen auf die nichtflüchtigen Anteile des Gemischs. Von dieser Menge können 2 bis 20, bevorzugt 5 bis 10 Gew.-%, auf die gleiche Basis bezogen, aus Polyurethanen der oben angegebenen allgemeinen Formel bestehen.

Die erfindungsgemässen Gemische können ausser den oben beschriebenen vernetzbaren Polymeren noch andere bekannte, bevorzugt gesättigte Bindemittel enthalten. Vorzugsweise werden wasserunlösliche, in wässrig-alkalischen Lösungen lösliche oder mindestens quellbare Bindemittel verwendet.

Die Gemische können weiterhin niedermolekulare thermisch vernetzende Verbindungen enthalten, wie sie in der EP-A 73 444 beschrieben sind, insbesondere Methoxymethylmelamine. Von diesen Verbindungen können 0,5-30, vorzugsweise 5-25 Gew.-%, bezogen auf die nichtflüchtigen Bestandteile des Gemischs, zugesetzt werden.

Als Photoinitiatoren in dem erfindungsgemässen Gemisch können eine Vielzahl von Substanzen Verwendung finden. Beispiele sind Benzoin und seine Derivate, Mehrkernchinone, Trichlormethyl-s-triazine, Acridinderivate, z.B. 9-Phenyl-acridin, 9-p--Methoxy-phenyl-acridin, 9-Acetylamino-acridin, Benz(a)acridin; Phenazinderivate, z.B. 9,10-Dimethylbenz(a)phenazin, 9-Meth-benz(a)phenazin, 10--Methoxybenz(a)-phenazin, Chinoxalinderivate, z.B. 6,4',4''-Trimethoxy-2,3-diphenylchinoxalin, 4',4''--Dimethoxy-2,3-diphenyl-5-azachinoxalin oder Chinazolinderivate. Die Acridin-, Phenazin- und Chinoxalinderivate werden bevorzugt. Die Photoinitiatoren werden allgemein in einer Menge von 0,01 bis 10, vorzugsweise von 0,05 bis 2 Gew.-% verwendet.

Vorzugsweise enthalten die Gemische mindestens einen Farbstoff, um die entwickelte Resistschablone besser sichtbar zu machen. Dabei wird mit Vorteil eine Kombination von mindestens zwei Farbstoffen verwendet, von denen der eine bei Bestrahlung seine Farbe ändert und bei Temperaturen oberhalb 200°C zerstört, d.h. farblos wird. Der andere Farbstoff soll sowohl die Bestrahlung als auch Temperaturen oberhalb 200°C ohne Veränderung überstehen. Er soll die Lötstopmaske während des Lötens und danach deutlich sichtbar machen.

Als Farbstoffe, die bei Belichtung einen Farbumschlag zeigen, sind z.B. Triphenylmethanfarbstoffe und bestimmte Azofarbstoffe, wie sie in der DE-A 2 807 933 (= US-A 4 241 166) beschrieben sind, geeignet.

Als licht- und hitzebeständige Farbstoffe sind Oxazolonfarbstoffe, z.B. ein Farbstoff der Formel

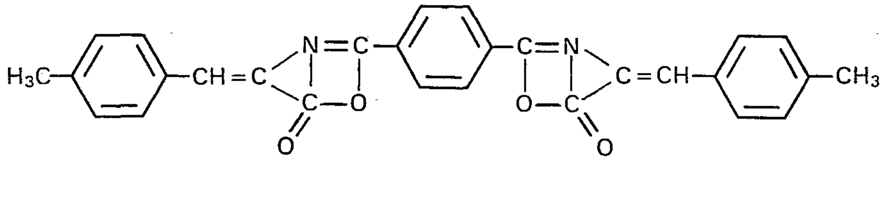

oder Anthrachinonfarbstoffe, z.B. das 1,4-Bis-(4--tert.butoxy-phenylamino)-5,8-dihydroxy-anthrachinon, geeignet.

Die erfindungsgemässen Gemische können ausser Monomeren, Bindemitteln, Photoinitiatoren und Farbstoffen noch eine Reihe weiterer üblicher Zusätze enthalten, z.B. Inhibitoren zur Verhinderung der termischen Polymerisation der Monomeren, Wasserstoffdonatoren, sensitometrische Regler, Pigmente, Weichmacher und Flammschutzmittel.

Das erfindungsgemässe Gemisch findet bevorzugt Anwendung als Photoresist, insbesondere als Lötstopmaske. Dazu kann es in bekannter Weise aus einer Lösung oder als vorgefertigte übertragbare Trockenresistfolie auf das zu bearbeitende Werkstück, z.B. eine Leiterplatte, aufgebracht werden. Das Gemisch wird bevorzugt zu einem Trockenresistmaterial verarbeitet. Im allgemeinen wird eine Lösung des Gemischs in einem Lösemittel auf einen geeigneten Schichtträger, z.B. eine Polyesterfolie, aufgebracht und getrocknet. Die Schichtdicke der Resistschicht kann etwa 10 bis 150, vorzugsweise 20 bis 120 µm betragen. Die freie Oberfläche der Schicht wird vorzugsweise mit einer Deckfolie, z.B. aus Polyethylen oder Polypropylen, abgedeckt. Das fertige Laminat kann als Grossrolle gespeichert und bei Bedarf zu Resistrollen beliebiger Breite zerschnitten werden.

Die Resistrollen bleiben auch nach einer Lagerung von Monaten bei 20°C unverändert und lassen sich problemlos verarbeiten, die Schnittkanten sind völlig frei von zur Verklebung führenden Resistaustritten. Die über 2 Monate bei 40°C im Trockenschrank gelagerten Resistschichten zeigen gegenüber frisch hergestellten Schichten keinen Unterschied bezüglich Laminierbarkeit, Entwickelbarkeit und Lötresistenz.

Die Folien lassen sich mit in der Trockenresisttechnik üblichen Geräten verarbeiten. In einer handelsüblichen Laminiervorrichtung wird die Deckfolie abgezogen und die Lötstopresistschicht auf die zu schützende, z.B. mit metallisierten Bohrungen versehene, Leiterplatte laminiert. Die so präparierte Platte wird dann durch eine Vorlage belichtet, die die Teile der Platte vor der Bestrahlung schützt, die für den Lötvorgang freibleiben müssen.

Entwickelt werden die von der Trägerfolie befreiten Resistschichten in bekannter Weise. Als Entwickler sind wässrige, vorzugsweise wässrigalkalische Lösungen, z.B. von Alkaliphosphaten, -carbonaten oder -silikaten, geeignet, denen gegebenenfalls kleine Mengen, z.B. bis zu 10 Gew.-% an mit Wasser mischbaren organischen Lösungsmitteln oder Netzmitteln zugesetzt werden können.

Fertig präparierte, nach den eben beschriebenen Verfahrenschritten abgedeckte Leiterplatten müssen nun vor dem Lötprozess einer Temperaturbehandlung unterzogen werden.

Es wird angenommen, dass sich hierbei ein interpenetrierendes Netzwerk ausbildet, dass die guten mechanischen, thermischen und chemischen Eigenschaften der Lötstopmasken bewirkt. Diese thermische Behandlung erfolgt im allgemeinen zwischen 80°C und 150°C, bei ungefähren Behandlungszeiten von 10 bis 60 Minuten.

Die lötbereite Platte kann mit elektronischen Bauelementen bestückt werden, deren Anschlussstücke über die entsprechenden Leitungen der Schaltung in den Bereichen, die im Entwicklungsprozess freigelegt wurden, gebogen werden.

Die Leitungsseite der Platte kann dann mit einem passenden, handelsüblichen Flussmittel behandelt und über eine handelsübliche Schwall-Lötmaschine der Schwall-Lötung unterworfen werden.

Als Lötmittel dienen bekannte eutektische Gemische, die Löttemperaturen von etwa 230° bis 260°C gestatten. Ein bekanntes Gemisch enthält beispielsweise 63 Gew.-% Zinn und 37 Gew.-% Blei.

Auch für Verfahren, bei denen doppelseitige, durchkontaktierte Leiterplatten durch Eintauchen in flüssige Metallbäder gelötet werden, lassen sich die erfindungsgemässen Lötstopmasken mit Erfolg einsetzen.

Die erfindungsgemässen Gemische ergeben Lötstopresistschichten, die sich durch Flexibilität und mechanische Festigkeit im unbelichteten und belichteten Zustand und durch eine hohe Temperaturresistenz im belichteten und nachgehärteten Zustand auszeichnen. Die photopolymerisierbaren Schichten weisen in Kombination mit den bevorzugten Photoinitiatoren eine hohe Lichtempfindlichkeit auf und ergeben auch bei hoher Schichtdicke eine gute Durchhärtung bzw. Durchvernetzung. Die belichteten Schichten lassen sich auch bei Schichtdicken oberhalb 100 µm einwandfrei und vollständig mit wässrig-alkalischen Lösungen entwickeln.

Die belichteten und entwickelten Schichten lassen sich ohne übermässige Beeinträchtigung der Flexibilität der Maske oder ihrer Haftung auf der Unterlage und ohne Veränderung der Lage und Dimensionen der durch Entwicklung freigelegten Bereiche thermisch härten. Die gehärteten Masken sind gegenüber atmosphärischen, thermischen und insbesondere chemischen Einflüssen über längere Zeiträume beständig.

So wird z.B. selbst nach 24stündiger Einwirkung von Ethanol keine Erweichung der Masken beobachtet. Es werden auch keine Bestandteile, z.B. Farbstoff, aus der Schicht herausgelöst. Die Lötstopmaske haftet nach der Lösungsmittelbehandlung unverändert gut sowohl auf den Leiterzügen als auch auf dem Basismaterial. Diese Resistenz ist ausserordentlich wichtig, da zur Flussmittelentfernung alkoholhaltige Lösungen Anwendung finden. Die aus den erfindungsgemässen Gemischen erhaltenen Lötstopmasken eignen sich in besonderem Masse dazu, empfindliche elektronische Leiterstrukturen vor atmosphärischen Angriffen wirksam und dauerhaft zu schützen.

Obwohl die Erfindung in der vorstehenden Beschreibung bevorzugt in ihrer Anwendung auf die Herstellung von Lötstopmasken beschrieben wurde, ist sie nicht auf diese Anwendung beschränkt. Sie ist in allen Fällen anwendbar, wo es darauf ankommt, bildmässige Schablonen von besonders hoher thermischer, mechanischer und chemischer Resistenz zu erzeugen. Das ist der Fall auch bei anderen Photoresistanwendungen, z.B. bei der Erzeugung von Galvanoschablonen, die gegenüber aggressiven Bädern und/oder bei erhöhten Temperaturen resistent sein sollen.

Die Verarbeitung des Gemischs erfolgt — wie oben beschrieben — bevorzugt nach der Trockenphotoresisttechnik. Das Gemisch eignet sich aber auch gut zur Verarbeitung nach der Flüssigresisttechnik, d.h. durch Aufbringen einer Lösung der Bestandteile auf den endgültigen Schichtträger sowohl bei der Leiterplattenfertigung als auch bei der Herstellung von Lötstopmasken.

Das erfindungsgemässe Gemisch ist auch zur Herstellung von Offsetdruckplatten, z.B. auf Aluminium, Stahl oder Chrom als Trägermaterial, geeignet, die bekannter Weise nach dem Entwickeln zur Verfestigung der Bildschablone eingebrannt werden sollen. Dieses Verfahren ist in der GB-A 1 154 749 beschrieben. Bei dieser Anwendungsweise sollte allerdings kürzere Zeit und auf höhere Temperaturen erhitzt werden, im allgemeinen 2 bis 20 Minuten auf Temperaturen im Bereich von 200 bis 250°C. Hierdurch kann die Druckauflage wesentlich gesteigert werden.

Die folgenden beispiele erläutern einzelne Ausführungsformen des erfindungsgemässen Gemischs. Wenn nichts anderes angegeben ist, sind Prozentzahlen und Mengenverhältnisse in Gewichtseinheiten zu verstehen. Die Mengen sind in den Rezepturen in Gewichtsteilen (Gt) angegeben.

*Beispiel 1*

Es wurden Beschichtungslösungen hergestellt aus:

52 Gt eines der folgenden Terpolymerisate
- a) N-Butoxymethyl-methacrylamid, Methacrylsäure, Hexylmethacrylat (25:25:50),
- b) N-Butoxymethyl-methacrylamid, Methacrylsäure, Decylmethacrylat (23:30:47),
- c) N-Butoxymethyl-methacrylamid, Acrylsäure, Hexylmethacrylat (47:18:35) oder
- d) (Vergleich) Styrol, Methacrylsäure, Hexylmethacrylat (10:30:60),

17,6 Gt Polyethylenglykol-400-dimethacrylat,
4 Gt Hexamethoxymethyl-melamin,
0,8 Gt 9-Phenylacridin,
0,04 Gt eines blauen Azofarbstoffs, erhalten durch Kuppeln von 2,4-Dinitro-6-chlor-benzoldiazoniumsalz mit 2-Metoxy-5-acetylamino-N,N-diethylanilin, und
0,12 Gt 1,4-Bis-(4-tert.butoxy-phenylamino)-5,8-dihydroxyanthrachinon in
90 Gt Butanon und
50 Gt Ethanol.

Mit den angegebenen Lösungen wurde jeweils eine biaxial verstreckte und thermofixierte Polyethylenterephthalatfolie der Stärke 25 µm mittels einer Beschichtungsmaschine beschichtet. Nach Durchlaufen einer Trockenzone hatten die Resistschichten eine Dicke von jeweils 100 µm und wurden mit einer Polypropylenfolie abgedeckt. Die so gefertigten Trockenresistfolien wurden anschliessend mittels eines Rollenschneiders zu handlichen Resistrollen einer Breite von 30 cm und einer Bahnlänge von 50 m zerschnitten.

Die Resistschichten wurden nach Abziehen der Deckfolie mit einer handelsüblichen Laminiervorrichtung bei 115°C auf eine mit 35 µm starker Kupferfolie kaschierte Phenoplast-Schichtstoffplatte laminiert und 20 Sekunden mit einem handelsüblichen Belichtungsgerät (5 kW Metallhalogenid-Lampe) belichtet. Als Vorlage diente ein 13stufiger Belichtungskeil mit Dichteinkrementen von 0,15. Anschliessend wurden die Platten mit 0,8%iger Sodalösung in einem Sprühprozessor entwickelt.

In der folgenden Tabelle sind die Entwicklungszeiten t sowie die vollvernetzten Keilstufen, in Klammern die Gesamtzahl einschliesslich der teilweise gedeckten Stufen, angegeben.

| | a) | b) | c) | d) (Vergleich) |
|---|---|---|---|---|
| Keilstufen | 10 (11) | 9 (10) | 6 (8) | 8 |
| t (Sek.) | 110 | 200 | 105 | 105 |

Für Lötversuche wurden Testplatten aus Epoxid-Glas-Hartgewebe mit ca. 65 µm starken Leiterbahnen mit einer verzinnten Oberfläche und durchkontaktierten Löchern verwendet. Die Leiterbahnbreiten und -abstände lagen zwischen 200 und 1000 µm, die Lochdurchmesser betrugen 0,6 bis 4 mm.

Auf diese Platten wurden die oben beschriebenen Lötstopresistschichten mit einer handelsüblichen Laminiervorrichtung bei 115°C laminiert.

Dann wurden die Platten durch eine Belichtungsvorlage, die die zu lötenden Augen abdeckte, 20 Sekunden belichtet, mit 0,8%iger Sodalösung entwickelt und trocken geblasen. Die so präparierten Leiterplatten wurden dann in einem Trockenschrank 60 Minuten bei 150°C gehärtet. Die abgekühlten Platten wurden anschliessend mit dem Flussmittel TL 33-16 der Firma Alpha Grillo benetzt und sodann mit einer Geschwindigkeit von 1 m/min über ein handelsübliches Lötschwallbad von 250°C geführt.

Alle gelöteten Platten zeigten keinerlei Abplatzungen. Auf den Lötstopresistoberflächen a), b) und c) waren keine Zinnreste zu beobachten, Schicht d) wies deutlich sogenannte «Zinnspinnweben» auf.

Die Platten wurden nach dem Löten je 1 Minute in einer Mischung aus 65 Gew.-% 1,1,2-Trichlor-1,2,2-trifluorethan und 35 Gew.-% 2-Propanol sowie in reinem 1,1,2-Trichlor-1,2,2-trifluorethan in einem Ultraschallbad gereinigt.

Vor und nach der Lösungsmittelbehandlung wurden die Härten der Lötstopmaske bestimmt. Hierzu wurde die Eindruck-Härteprüfung nach Buchholz, beschrieben in DIN 53 153, angewandt.

Bei dieser Prüfung wird mittels eines geeigneten Geräts das Eindringen eines Kreismessers in die zu prüfende Schicht unter definierter Belastung gemessen. Dabei wird ein Eindruck erhalten, der umso länger ist, je weicher das zu prüfende Material war. Als Härtezahl wird dann der Wert

$$\frac{100}{\text{Eindrucklänge in mm}}$$

angegeben. Das Verhältnis der Härtewerte vor und

nach der Lösungsmittelbehandlung gibt zusätzlich ein Mass für die Erweichbarkeit bzw. Quellbarkeit der Schicht durch organische Lösungsmittel.

Ausserdem wurden Teile der gelöteten Platten 24 Stunden in Ethanol gelegt, um die Lösemittelresi stenz und damit die Aushärtung zu prüfen.

Die Ergebnisse sind in der folgenden Tabelle zusammengestellt:

| | a) | b) | c) | d) (Vergleich) |
|---|---|---|---|---|
| Buchholzhärte vor/nach Reinigung | 80/79 | 82/83 | nicht bestimmt | 72/48 |
| 24 Std. Ethanol | Lötstopmaske unverändert aut Leiterplatte | | | Farbstoff aus Lötstopmaske herausgelöst |

*Beispiel 2*

Es wurden folgende Beschichtungslösungen hergestellt:

52 Gt eines der folgenden Terpolymerisate:
a) N-Butoxymethyl-methacrylamid, Acrylsäure, Hexamethacrylat (26:22:52)
b) N-Butoxymethyl-methacrylamid, Methacrylsäure, Ethylacrylat (31:32:37),
4 Gt eines elastomeren Reaktionsprodukts aus Glycidylmethacrylat, Adipinsäure und einem oligomeren Diisocyanat, das durch Umsetzen von Tolylendiisocyanat mit einem Polytetramethylenetherdiol erhalten worden war (vgl. DE-A 3 036 694),
17,6 Gt Polyethylenglykol-400-dimethacrylat,
4 Gt Hexamethoxymethyl-melamin,
0,8 Gt 9-Phenylacridin,
0,04 Gt des in Beispiel 1 erwähnten blauen Farbstoffs,
0,12 Gt des in Beispiel 1 erwähnten Anthrachinonfarbstoffs in
80 Gt Butanon und
50 Gt Ethanol.

Mit den Lösungen wurden, wie in Beispiel 1 beschrieben, 100 µm dicke Lötstopresistschichten hergestellt. Die Schichten wurden, wie in Beispiel 1 beschrieben, verarbeitet. Die Ergebnisse sind der folgenden Tabelle zu entnehmen:

| | a) | b) |
|---|---|---|
| Belichtungszeit (Sek.) | 20) | 20 |
| Keilstufen | 6 (8) | 7 (10) |
| t (Sek.) | 65 | 120 |
| 24 Std. Ethanol | Lötstopmaske unverändert auf der Leiterplatte | |

*Beispiel 3*

Analog Beispiel 1 wurden folgende Beschichtungslösungen eingesetzt:

a)
39 Gt eines Styrol-Methacrylsäure-Hexylmethacrylat-Terpolymerisats (10:30:60),
13 Gt eines N-Methoxymethyl-methacrylamid-Hexylmethacrylat-Copolymerisats (50:50),
8 Gt des in Beispiel 2 beschriebenen Elastomeren,
22 Gt Polyethylenglykol-400-dimethacrylat,
5 Gt Hexamethoxymethyl-melamin,
1 Gt 9-Phenylacridin,
0,05 Gt des blauen Farbstoffs aus Beispiel 1 und
0,15 Gt des Anthrachinonfarbstoffs aus Beispiel 1 in
210 Gt Butanon.

b)
52 Gt eines N-Butoxymethyl-methacrylamid-Methacrylsäure-Hexylmethacrylat-Terpolymerisats (36:28:36),
6,4 Gt des in Beispiel 2 angegebenen Elastomeren,
17,6 Gt Polyethylenglykol-400-dimethacrylat,
4 Gt Hexamethoxymethyl-melamin,
0,8 Gt 9-Phenylacridin,
0,04 Gt des blauen Farbstoffs aus Beispiel 1 und
0,12 Gt des Anthrachinonfarbstoffs aus Beispiel 1 in
90 Gt Butanon und
70 Gt Ethanol.

Auch hier wurden Lötstopmasken mit sehr guter Lösemittelresistenz erhalten, die nach dem Löten keine Zinnspinnweben aufwiesen. Die Ergebnisse sind in der folgenden Tabelle zusammengefasst:

| | a) | b) |
|---|---|---|
| Belichtungszeit (Sek.) | 20 | 20 |
| Keilstufen | 7 (9) | 9 |
| t (Sek.) | 120 | 80 |
| Buchholzhärte vor/nach Reinigung | 59/60 | 86/79 |
| 24 Std. Ethanol | Lötstopmaske unverändert auf der Leiterplatte | |

*Beispiel 4*

Es wurde eine Beschichtungslösung hergestellt aus:

2 Gt des Terpolymerisats aus Beispiel 1a,
2 Gt eines Diurethans, hergestellt aus 2 mol Glycerindimethacrylat und 1 mol Hexamethylendiisocyanat,
0,7 Gt 9-Phenylacridin und
0,07 Gt eines blauen Azofarbstoffs, erhalten durch Kuppeln von 2,4-Dinitro-6-chlorbenzoldiazoniumsalz mit 2-Methoxy-5--acetylamino-N-cyanoethyl-N-hydroxyethylanilin in

30 Gt Butanon,
12 Gt Butylacetat und
12 Gt Ethylenglykolmonomethylether.

Die Lösung wurde auf elektrochemisch aufgerauhtes und anodisiertes Aluminium mit einer Oxidschicht von 2 g/m², das mit einer wässrigen Lösung von Polyvinylphosphonsäure vorbehandelt war, so aufgeschleudert, dass ein Trockengewicht von 4 g/m² erhalten wurde. Anschliessend wurde die Platte mit einer Polyvinylalkohol-Deckschicht von 4 g/m² versehen. Die Druckplatte wurde halbiert, und beide Hälften wurden mittels einer 5 kW-Metallhalogenidlampe unter einem 13stufigen Halbtonkeil sowie unter einem 60er- und 120er-Rasterstufenkeil 2 Sekunden belichtet.

Anschliessend wurde mit einem Entwickler folgender Zusammensetzung entwickelt:

3,0 Gt Natriummetasilikat · 9 $H_2O$,
0,03 Gt nichtionogenes Netzmittel (Kokosfettalkohol-Polyoxyethylenether mit ca. 8 Oxyethyleneinheiten),
0,003 Gt Antischaummittel und
96,967 Gt vollentsalztes Wasser.

Es wurden 5 (6) vollvernetzte Keilstufen erhalten. Eine Hälfte der Flachdruckplatte wurde nach dem Entwickeln 5 Minuten bei 230°C eingebrannt.

Vergleichende Druckversuche zeigten eine erhöhte Druckauflage der eingebrannten Druckplatte.

*Beispiel 5*

Die in Beispiel 4 angegebene Beschichtungslösung wurde auf eine mit 35 µm starker Kupferfolie kaschierte Phenoplast-Schichtstoffplatte so aufgeschleudert, dass nach dem Trocknen ein Schichtgewicht von 7 g/m² erhalten wurde.

Die Platte wurde 40 Sekunden durch eine Strichvorlage mit Linienbreiten und Abständen bis herab zu 80 µm belichtet und anschliessend 60 Sekunden mit 0,8%iger Natriumcarbonatlösung entwickelt. Es wurde dann mit ammoniakalischer Kupferchloridlösung (pH 8,5) bei 48°C geätzt und die Resistschablone mit 5%iger wässriger KOH-Lösung bei 50°C entfernt.

Die Kupferstrukturen waren einwandfrei wiedergegeben.

*Beispiel 6*

Eine Lösung aus

13 Gt des in Beispiel 1 a) angegebenen Terpolymerisats,
6,4 Gt Polyethylenglykol-400-dimethacrylat,
0,2 Gt 9-Phenylacridin,
0,01 Gt des Azofarbstoffs 5-Nitro-2-[2-methyl-4-(N-ethyl-N-cyanoethyl)amino-phenylazo-] benzthiazol und
0,02 Gt des blauen Farbstoffs aus Beispiel 4 in
18 Gt Butanon und
18 Gt Ethanol

wurde auf eine biaxial vestreckte und thermofixierte Polyethylenterephthalatfolie der Stärke 25 µm so aufgeschleudert, dass nach dem Trocknen bei 100°C ein Schichtgewicht von 40 g/m² erhalten wurde.

Die so hergestellte Trockenresistfolie wurde mit einer handelsüblichen Laminiervorrichtung bei 120°C auf eine vorgewärmte, mit 35 µm starker Kupferfolie kaschierte Phenoplast-Schichtstoffplatte laminiert und 4 Sekunden mit einem handelsüblichen Belichtungsgerät belichtet. Als Vorlage diente eine Strichvorlage mit Linienbreiten und Abständen bis herab zu 80 µm.

Nach der Belichtung wurde die Polyesterfolie abgezogen und die Schicht mit 0,8%iger Natriumcarbonatlösung in einem Sprühentwicklungsgerät 90 Sekunden lang entwickelt.

Die Platte wurde dann 30 Sekunden mit Leitungswasser gespült, 30 Sekunden in einer 15%igen Ammoniumperoxydisulfat-Lösung angeätzt, erneut mit Wasser gespült, 30 Sekunden in 10%ige Schwefelsäure getaucht und sodann nacheinander in den folgenden Elektrolytbädern galvanisiert:

1. 50 Minuten in einem Kupferelektrolytbad der Firma Schlötter, Geislingen/Steige, Typ «Glanzkupfer-Bad PC»

Stromdichte: 2,5 A/dm²
Metallaufbau: ca. 25 µm
Temperatur: Raumtemperatur

2. 15 Minuten in einem Bleizinnbad LA der Firma Schlötter, Geislingen/Steige

Stromdichte: 2 A/dm²
Metallaufbau: 15 µm
Temperatur: Raumtemperatur.

Die Platte zeigte keinerlei Unterwanderungen oder Beschädigungen.

Die Platte konnte sodann in 5%iger KOH-Lösung bei 50°C entschichtet und das freigelegte Kupfer in den üblichen Ätzmedien weggeätzt werden.

*Beispiel 7*

Es wurde analog Beispiel 6 eine Resistschicht unter Verwendung folgender Beschichtungslösung hergestellt:

6,5 Gt des Terpolymerisats aus Beispiel 1 a),
5,6 Gt eines Umsetzungsprodukts aus 1 mol Trimethylhexamethylendiisocyanat und 2 mol Hydroxyethylmethacrylat,
0,2 Gt 9-Phenylacridin und
0,035 Gt des blauen Farbstoffs aus Beispiel 4 in
14 Gt Butanon und
9 Gt Ethanol.

Die Belichtung, Entwicklung und Galvanisierung wurde, wie in Beispiel 6 beschrieben, durchgeführt.

Auch diese Platte zeigte keine Unterwanderungen oder Beschädigungen.

**Patentansprüche**

1. Durch Strahlung polymerisierbares Gemisch, enthaltend

a) eine Verbindung mit mindestens zwei endständigen ethylenisch ungesättigten Gruppen, die durch radikalisch initiierte Additionskettenpolymerisation ein vernetztes Polymerisat zu bilden vermag,
b) ein polymeres Bindemittel und
c) einen durch Strahlung aktivierbaren Polymerisationsinitiator

dadurch gekennzeichnet, dass es als Bindemittel ein Mischpolymerisat mit Einheiten der Formel

R′
|
-$CH_2$-C-
|
CO
|
NH
|
$CH_2$
|
OR

enthält, worin
R′ ein Wasserstoffatom oder eine Methylgruppe ist und
R ein Wasserstoffatom, eine niedere Alkyl-, Acyl- oder Hydroxyalkylgruppe ist.

2. Durch Strahlung polymerisierbares Gemisch nach Anspruch 1, dadurch gekennzeichnet, dass das Mischpolymerisat ferner Einheiten mit seitenständigen Carboxylgruppen enthält.

3. Durch Strahlung polymerisierbares Gemisch nach Anspruch 2, dadurch gekennzeichnet, dass das Mischpolymerisat ein Terpolymerisat aus

a) Methacrylsäure oder Acrylsäure,
b) einem Acryl- oder Methacrylamid mit $ROCH_2$-Gruppen am Stickstoff und
c) einem Alkylacrylat oder -methacrylat ist.

4. Durch Strahlung polymerisierbares Gemisch nach Anspruch 3, dadurch gekennzeichnet, dass das Terpolymerisat 10 bis 35 Gew.-% aus Acryl- oder Methacrylsäure, 15 bis 60 Gew.-% aus substituiertem Acryl- oder Methacrylamid und 25 bis 75 Gew.-% aus einem Alkylacrylat oder -methacrylat entstandene Einheiten enthält.

5. Durch Strahlung polymerisierbares Gemisch nach Anspruch 4, dadurch gekennzeichnet, dass die Komponente c) ein Alkylmethacrylat mit 4 bis 12 Kohlenstoffatomen in der Alkylgruppe ist.

6. Durch Strahlung polymerisierbares Gemisch nach Anspruch 1, dadurch gekennzeichnet, dass es 40 bis 90 Gew.-% Bindemittel, 10 bis 60 Gew.-% polymerisierbare Verbindung und 0,01 bis 10 Gew.-% Initiator enthält.

7. Durch Strahlung polymerisierbares Gemisch nach Anspruch 1, dadurch gekennzeichnet, dass es zusätzlich eine mit dem Bindemittel oder der polymerisierbaren Verbindung bei erhöhter Temperatur unter Vernetzung reagierende niedermolekulare Verbindung enthält.

8. Durch Strahlung polymerisierbares Gemisch nach Anspruch 5, dadurch gekennzeichnet, dass das Terpolymerisat ein Polymerisat aus Methacrylsäure, N-Butoxymethyl-methacrylamid und Hexylmethacrylat ist.

9. Durch Strahlung polymerisierbares Kopiermaterial mit einem flexiblen transparenten temporären Schichtträger und einer übertragbaren thermoplastischen, durch Strahlung polymerisierbaren Schicht, die

a) eine Verbindung mit mindestens zwei endständigen ethylenisch ungesättigten Gruppen, die durch radikalisch initiierte Additionskettenpolymerisation ein vernetztes Polymerisat zu bilden vermag,
b) ein polymeres Bindemittel und
c) einen durch Strahlung aktivierbaren Polymerisationsinitiator

enthält, dadurch gekennzeichnet, dass die Schicht als Bindemittel ein Mischpolymerisat mit Einheiten der Formel

R′
|
-$CH_2$-C-
|
CO
|
NH
|
$CH_2$
|
OR

enthält, worin
R′ ein Wasserstoffatom oder eine Methylgruppe ist und
R ein Wasserstoffatom, eine niedere Alkyl-, Acyl- oder Hydroxyalkylgruppe ist.

10. Verfahren zur Herstellung einer Lötstopmaske, bei dem man eine trockene, feste photopolymerisierbare Photoresistschicht, die als wesentliche Bestandteile

a) eine Verbindung mit mindestens zwei endständigen ethylenisch ungesättigten Gruppen, die durch radikalisch initiierte Additionskettenpolymerisation ein vernetztes Polymerisat zu bilden vermag,
b) ein polymeres Bindemittel und
c) einen durch Strahlung aktivierbaren Polymerisationsinitiator

enthält und die sich auf einem transparenten temporären Schichtträger befindet, unter Druck und Erwärmen auf die Oberfläche einer gedruckten Schaltung laminiert, bildmässig unter Aussparung der Lötaugen belichtet, den temporären Schichtträger abzieht, die unbelichteten Schichtbereiche mit einem Entwickler auswäscht und die erhaltene Lötstopmaske auf erhöhte Temperatur erwärmt, dadurch gekennzeichnet, dass die Photoresistschicht

als Bindemittel ein Mischpolymerisat mit Einheiten der Formel

R'
|
$-CH_2-C-$
|
CO
|
NH
|
$CH_2$
|
OR

enthält, worin

R' ein Wasserstoffatom oder eine Methylgruppe ist und

R ein Wasserstoffatom, eine niedere Alkyl-, Acyl- oder Hydroxyalkylgruppe ist.

**Claims**

1. A radiation-polymerizable mixture which contains

a) a compound which has at least two terminal ethylenically unsaturated groups and which can form a cross-linked polymer by means of chain polymerization by addition, initiated by free radicals,
b) a polymeric binder, and
c) a polymerization initiator which can be activated by radiation,

characterized in that it contains, as a binder, a copolymer with units of the formula

R'
|
$-CH_2-C-$
|
CO
|
NH
|
$CH_2$
|
OR

R' denoting a hydrogen atom or a methyl group, and
R being a hydrogen atom, a lower alkyl group, acyl group or hydroxyalkyl group.

2. A radiation-polymerizable mixture as claimed in Claim 1, wherein the copolymer furthermore includes units with lateral carboxyl groups.

3. A radiation-polymerizable mixture as claimed in Claim 2, wherein the copolymer is a terpolymer of

a) methacrylic acid or acrylic acid,
b) an acryl- or methacrylamide with $ROCH_2$-groups at the nitrogen, and
c) an alkyl acrylate or alkyl methacrylate.

4. A radiation-polymerizable mixture as claimed in Claim 3, wherein the terpolymer comprises 10 to 35 percent by weight of units formed by acrylic or methacrylic acid, 15 to 60 per cent by weight of units formed by substituted acryl- or methacrylamide and 25 to 75 per cent by weight of units formed by an alkyl acrylate or alkyl methacrylate.

5. A radiation-polymerizable mixture as claimed in Claim 4, wherein component c) is an alkyl methacrylate which has 4 to 12 carbon atoms in its alkyl group.

6. A radiation-polymerizable mixture as claimed in Claim 1, wherein 40 to 90 per cent by weight of binder, 10 to 60 per cent by weight of polymerizable compound and 0.01 to 10 per cent by weight of initiator are contained.

7. A radiation-polymerizable mixture as claimed in Claim 1, wherein additionally a low molecular weight compound is contained which at an elevated temperature reacts with cross-linking with the binder or the polymerizable compound.

8. A radiation-polymerizable mixture as claimed in Claim 5, wherein the terpolymer is a polymer of methacrylic acid, N-butoxymethyl methacrylamide and hexyl methacrylate.

9. A radiation-polymerizable copying material comprised of a flexible, transparent temporary layer support and a transferable thermoplastic radiation-polymerizable layer which contains

a) a compound which has at least two terminal ethylenically unsaturated groups and which can form a cross-linked polymer by means of chain polymerization by addition, initiated by free radicals,
b) a polymeric binder, and
c) a polymerization initiator which can be activated by radiation,

characterized in that the layer contains, as a binder, a copolymer with units of the formula

R'
|
$-CH_2-C-$
|
CO
|
NH
|
$CH_2$
|
OR

R' denoting a hydrogen atom or a methyl group, and
R being a hydrogen atom, a lower alkyl group, acyl group or hydroxyalkyl group.

10. A process for producing a solder mask, in which a dry solid photopolymerizable photoresist layer, containing as the essential constituents

a) a compound which has at least two terminal ethylenically unsaturated groups and which can form a cross-linked polymer by means of chain polymerization by addition, initiated by free radicals,

b) a polymeric binder, and
c) a polymerization initiator which can be activated by radiation,

and being present on a transparent temporary layer support, is laminated onto the surface of a printed circuit by applying pressure and heat, is exposed imagewise with the exception of the solder pads, the temporary layer support is peeled off, the unexposed layer areas are washed out with a developer, and the resulting solder mask is heated to an elevated temperature, characterized in that the photoresist layer contains, as a binder, a copolymer with units of the formula

R'
|
$-CH_2-C-$
|
CO
|
NH
|
$CH_2$
|
OR

R' denoting a hydrogen atom or a methyl group, and
R being a hydrogen atom, a lower alkyl group, acyl group or hydroxyalkyl group.

## Revendications

1. Mélange polymérisable par irradiations, qui contient

a) un composé avec au moins deux groupes terminaux à insaturation éthylénique, qui peu former un polymère réticulé par polymérisation en chaîne par addition initiée par des radicaux libres,
b) un liant polymère et
c) un initiateur de polymérisation activable par irradiation, caractérisé en ce qu'il contient comme liant un copolymère ayant des unités de formule

R'
|
$-CH_2-C-$
|
CO
|
NH
|
$CH_2$
|
OR

dans laquelle
R' est un atome d'hydrogène ou un groupe méthyle et
R est un atome d'hydrogène ou un groupe alkyle, acyle ou hydroxyalkyle inférieur.

2. Mélange polymérisable par irradiation selon la revendication 1, caractérisé en ce que le copolymère contient en outre des unités avec des groupes carboxyles latéraux.

3. Mélange polymérisable par irradiation selon la revendication 2, caractérisé en ce que le copolymère est un terpolymère composé de

a) acide méthacrylique ou acide acrylique
b) un acrylamide ou un méthacrylamide avec des groupes $ROCH_2$ sur l'azote et
c) un acrylate ou méthacrylate d'alkyle.

4. Mélange polymrérisable par irradiation selon la revendication 3, caractérisé en ce que le terpolymère contient de 10 à 35% en poids d'unités dérivées d'acide acrylique ou méthacrylique, de 15 à 60% en poids d'unités dérivées d'acrylamide ou de méthacrylamide substitué et de 25 à 75% en poids d'unités dérivées d'un acrylate ou méthacrylate d'alkyle.

5. Mélange polymérisable par irradiation selon la revendication 4, caractérisé en ce que le constituant c) est un méthacrylate d'alkyle ayant de 4 à 12 atomes de carbone dans le groupe alkyle.

6. Mélange polymérisable par irradiation selon la revendication 1, caractérisé en ce qu'il contient de 40 à 90% en poids de liant, de 10 à 60% en poids de composé polymérisable et de 0,01 à 10% en poids d'initiateur.

7. Mélange polymérisable par irradiation selon la revendication 1, caractérisé en ce qu'il contient en outre un composé de faible masse moléculaire, réagissant à température élevée, avec réticulation, avec le liant ou avec le composé polymérisable.

8. Mélange polymérisable par irradiation selon la revendication 5, caractérisé en ce que le terpolymère est un polymère d'acide méthacrylique, de N-butoxyméthyl-méthacrylamide et de méthacrylate d'hexyle.

9. Matériau à copier polymérisable par irradiation avec un support flexible, transparent, temporaire, et une couche thermoplastique, transférable, polymérisable par irradiation qui contient:

a) un composé avec au moins deux groupes terminaux, à insaturation éthylénique, qui peu former un polymère réticulé par polymérisation en chaîne par addition initiée par des radicaux libres,
b) un liant polymère et
c) un initiateur de polymérisation activable par irradiation, lequel matériau est caractérisé en ce que la couche contient comme liant un copolymère avec des unités de formule

R'
|
$-CH_2-C-$
|
CO
|
NH
|
$CH_2$
|
OR

dans laquelle
R' est un atome d'hydrogène ou un groupe méthyle et

R est un atome d'hydrogène ou un groupe alkyle, acyle ou hydroxyalkyle inférieur.

10. Procédé pour la production d'un masque de brasage dans lequel, sur la surface d'un circuit imprimé, on applique sous pression et à chaud une couche de photorésist photopolymérisable, sèche, solide, qui contient comme constituants essentiels:

a) un composé avec au moins deux groupes terminaux à insaturation éthylénique, qui peu former un polymère réticulé par polymérisation en chaîne par addition, initiée par des radicaux libres,
b) un liant polymère et
c) un initiateur de polymérisation activable par irradiation, et qui se trouve sur un support transparent, temporaire, on expose selon une image à l'exception des pastilles de brasure, on enlève le support temporaire, on lave les domaines de couche non-exposés avec un agent de développement et on chauffe à température élevée le masque de brasage obtenu, lequel procédé est caractérisé en ce que la couche de photorésist contient comme liant un copolymère avec des unités de formule

R'
|
$-CH_2-C-$
|
CO
|
NH
|
$CH_2$
|
OR

dans laquelle
R' est un atome d'hydrogène ou un groupe méthyle et
R est un atome d'hydrogène, un groupe alkyle, acyle ou hydroxyalkyle inférieur.